Europäisches Patentamt

European Patent Office

Office européen des brevets

(19)

(11) Publication number: **0 093 513**

**A1**

(12)

# EUROPEAN PATENT APPLICATION

(21) Application number: **83301971.4**

(22) Date of filing: **07.04.83**

(51) Int. Cl.³: **H 01 L 31/06**
**H 01 L 31/18**

(30) Priority: **12.04.82 US 367811**

(43) Date of publication of application:
**09.11.83 Bulletin 83/45**

(84) Designated Contracting States:
**DE FR GB**

(71) Applicant: **CHEVRON RESEARCH COMPANY**
**525 Market Street**
**San Francisco California 94120(US)**

(72) Inventor: **Madan, Arun**
**21830 Cabrini Bld. Look Out Mountain**
**Golden, CA 80401(US)**

(74) Representative: **Kosmin, Gerald Emmanuel et al,**
**HASELTINE, LAKE & CO. Hazlitt House 28 Southampton**
**Buildings Chancery Lane**
**London, WC2A 1AT(GB)**

(54) Compensated amorphous silicon solar cell and method of fabrication thereof.

(57) A hydrogenated amorphous silicon solar cell (10) has a photoactive intrinsic silicon layer (14b) which is modified by the incorporation therein of N-type and P-type dopants so as to lower the bandgap energy of the layer to a level which is more closely aligned with the optimum bandgap energy for absorption of solar radiation (100). The dopants are incorporated in amounts such as to reduce the bandgap energy of the intrinsic layer to less than 1.6 eV whilst ensuring that the recombination lifetime of the compensated intrinsic layer is greater than the transit time of the layer of the holes and electrons generated in the layer during illumination of the solar cell. The solar cell can advantageously be fabricated in a glow discharge apparatus.

FIG.__1.

EP 0 093 513 A1

Compensated amorphous silicon solar cell and method of fabrication thereof

This invention relates to thin film solar cells and is concerned with thin film hydrogenated amorphous silicon solar cells.

Photovoltaic devices, such as solar cells, are capable of converting sunlight into usable electrical energy. The electrical energy conversion occurs as a result of what is well known in the solar cell field as the photovoltaic effect. Solar radiation impinging on a solar cell is absorbed by the semiconductor layer which generates electrons and holes. The electrons and holes are separated by a built-in electric field, for example, a rectifying junction, such as a P-I-N junction in the solar cell. The electrons flow towards the N-type region and the holes flow towards the P-type region. The separation of the electrons and holes across the rectifying junction results in the generation of an electric current, known as the photocurrent, and an electric voltage, known as the photovoltage.

For maximum conversion efficiency of sunlight into electrical energy, the semiconductor material should have a bandgap energy of about 1.5 electron volts. Photoactive intrinsic hydrogenated amorphous silicon based alloys, such as hydrogenated amorphous silicon, a-Si:H, or hydrogenated-fluorinated amorphous silicon, a-Si:F:H, has a bandgap energy, depending upon the method of fabrication, greater than about 1.7eV. Doped hydrogenated amorphous silicon alloys incorporating P-type dopants have a bandgap energy which is closer to or below the ideal bandgap energy. However, the doping increases the defect state density of the material. U.S. Patent 4,217,148 teaches adding a sufficient amount of a P-type conductivity modifier, such as boron, into the intrinsic amorphous silicon which is slightly N-type, to make the material less N-type and closer to a neutral state. However, incorporation of just enough P-type dopant to render the material intrinsic does not lower the bandgap of the material.

It is an object of the present invention to provide a compensated solar cell wherein the intrinsic layer has a lower bandgap which is more closely aligned with the optimum bandgap energy for absorption of solar radiation. It is another object to provide a cell wherein the greater absorption of the photoactive intrinsic region permits the fabrication of cells with a thinner active region and thus lowers the cost of the device and speeds the processing time. It is a further object to provide a cell having a compensated material fabricated by a method wherein the defects introduced during the doping process are offset by the increased absorption of the material due to the lower bandgap energy.

Thus in accordance with one aspect of the invention, there is provided a hydrogenated amorphous silicon solar cell which includes an electrically conductive substrate in contact with a body of hydrogenated amorphous silicon having layers of differing conductivity with at least one photoactive intrinsic hydrogenated amorphous silicon layer, said body of hydrogenated amorphous silicon having opposed first and second major surfaces, wherein said first major surface contacts said electrically conductive substrate, and means for electrically contacting said second major surface, characterized in that the photoactive intrinsic hydrogenated amorphous silicon layer is compensated by the incorporation therein of N-type and P-type dopants in amounts such as to reduce the bandgap energy of the layer to less than 1.6 eV while ensuring that the recombination lifetime of the

-3-

photoactive intrinsic layer is greater than the transit time out of said layer of the holes and electrons generated in said photoactive intrinsic layer during illumination of the solar cell.

In accordance with another aspect of the invention, there is provided a method of reducing the bandgap energy of a photoactive intrinsic hydrogenated amorphous silicon layer incorporated in a hydrogenated amorphous silicon solar cell, which method comprises:

incorporating a P-type dopant and an N-type dopant during the growth of said layer in amounts sufficient to reduce the bandgap energy of the photoactive intrinsic hydrogenated amorphous silicon layer to less than 1.6 eV, and to ensure that the recombination lifetime of holes and electrons is greater than the transit time of said holes and electrons out of said photoactive layer during illumination of the solar cell.

The hydrogenated amorphous silicon solar cell of the invention incorporates a photoactive intrinsic layer containing both N-type and P-type dopants. The N-type and P-type dopants are incorporated in the intrinsic layer only in a quantity sufficient to lower the bandgap of the photoactive intrinsic layer and thus increase the absorption of the cell without introducing sufficient defect state densities to offset the increased absorption. The concentration of the dopants need only be sufficient to permit a recombination lifetime in the photoactive intrinsic layer which is greater than the transit time of the electrons and holes to N-type and P-type regions respectively.

For a better understanding of the invention and to show how the same may be carried into effect, reference will now be made, by way of example, to the accompanyng drawing, in which:

FIG. 1 is a vertical cross-section of a P-I-N solar cell incorporating a compensated photoactive intrinsic layer; and

FIG. 2 is a vertical cross-section of a Schottky barrier solar cell incorporating a compensated photoactive intrinsic layer.

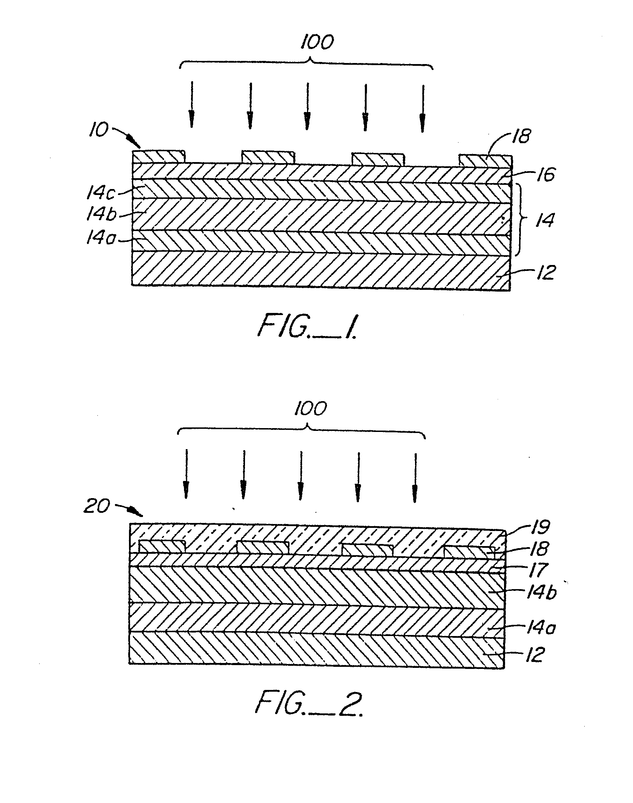

Referring now to the drawing, FIG. 1 depicts a P-I-N solar cell 10. The first mentioned letter is the incident layer of the solar cell. Solar radiation 100, impinging on solar cell 10, forms a reference point for the incident surface of each layer region of the solar cell. The solar cell 10 includes an electrically conductive substrate 12 made of, for example, stainless steel, molybdenum, or titanium. Optionally, the incident surface of the substrate 12 can be coated with a highly reflective layer of a metal, for example aluminium or chromium, to reflect solar radiation back into the photoactive semiconductor material. Alternatively, substrate 12 can be made of a transparent material, for example glass, coated with an electrically conductive material, such as a transparent conductive oxide (hereinafter referred to as TCO), for example tin oxide or indium tin oxide. If substrate 12 is, for instance, glass coated with a TCO, solar radiation can pass through the substrate side and into the solar cell. In this situation, the solar cell can be operated as either a P-I-N solar cell or an N-I-P solar cell.

A body of hydrogenated amorphous silicon alloy 14 is deposited upon substrate 12 by, for example, a glow discharge, chemical vapour deposition, or reactive sputtering. The body 14 has layers 14a, 14b and 14c of differing conductivity type. The layer 14a, contiguous to and deposited upon substrate 12, is doped $N^+$-type. The $N^+$-type conductivity of region 14a assures an ohmic contact to the conductive substrate 12. Layer 14a has a thickness generally of from 10 to 40 nanometers and preferably about 25 nanometers with a bandgap of about 1.8 eV and an N-type doping concentration of a suitable N-type dopant, such as phosphorus in the form of $PH_3$, of from 5,000 to 15,000 volume part per million (vol. ppm) and preferably about 10,000 vol. ppm. Region 14a is preferably graded in doping concentration from $N^+$-type contacting the substrate 12 to N-type at layer 14b.

The layer 14b of compensated photoactive intrinsic hydrogenated amorphous silicon is contiguous to layer 14a. The layer 14b has intrinsic properties but is doped with minor amounts of N-type and P-type dopants. The layer has a lower bandgap energy than that of uncompensated amorphous silicon, which is of the order of about 1.7-1.8 eV. Layer 14b is the photoactive region of the solar cell and absorbs the solar radiation to create the electrons and holes which flow toward regions 14a and 14c respectively. The photoactive region 14b incorporates sufficient P-type dopants, for example boron in the form of $B_2H_6$, to reduce the bandgap of the material from the bandgap of intrinsic material without dopants or $N^+$ type layer. A compensating amount of an N-type dopant is also added to layer 14b to reduce the defect state density of the material.

The P-type dopants are added to reduce the optical bandgap to the desired bandgap energy, preferably about 1.5 eV. However, the P-type dopants lower the Fermi level of the material below that of uncompensated photoactive intrinsic hydrogenated amorphous silicon. Therefore, sufficient N-type dopants are also added to bring the Fermi level of the intrinsic hydrogenated silicon back up to the level of uncompensated hydrogenated amorphous silicon. Preferably, the level of N-type dopants is adjusted so that the final solar cell has a Fermi level that moves through the lowst possible density of states such as to give the widest possible depletion width for the compensated intrinsic material contacting either a Schottky barrier metal or a different doped semiconductor material, such as P-type a-Si:H or P-type a-Si:F:H. The amount of N-type dopants added is such as to maximize the photoluminescense of hydrogenated amorphous silicon coupled with a conductivity activation energy of about 0.6 eV to about 0.8 eV and preferably about 0.7 eV.

Layer 14b has a thickness generally of from 250 to 400 nanometers, preferably about 350 nanometers. The increased absorption of the compensated region 14b permits the thickness of the layer to be reduced. An uncompensated intrinsic layer would have a thickness of from 400 to 1000 nanometers, preferably about 500 nanometers. The doping concentration is generally from 500 to 1500 vol. ppm of an N-type dopant and from 500 to 1500 vol. ppm of a P-type dopant. A preferred amount of each of the N-type and P-type dopants is from 800 to 1000 vol. ppm. The photoactive layer should have a bandgap energy less than 1.6 eV and preferably between 1.4 and 1.6 eV, most preferably about 1.5 eV. Th exact concentration pairing of the N-type and P-type dopants should be adjusted in layer 14b so that the recombination time is greater than the transit time of the electrons and holes out of the photoactive intrinsic region.

A layer 14c of P-type hydrogenated amorphous silicon is contiguous to the intrinsic layer 14b. Layer 14c is a hydrogenated amorphous silicon layer with a suitable P-type conductivity modifier, for example boron, aluminium, gallium or indium. Preferably, layer 14c is P-type at layer 14b and $P^{+}$-type at layer 16. The layer 14c should ohmically contact layer 16. The layer 14c is typically from about 20 to about 50 nanometers in thickness and preferably about 30 nanometers in thickness. The region 14c of P-type hydrogenated amorphous silicon has a bandgap energy of less than about 1.2 eV with a P-type doping concentration of about 20,000 to 40,000 vol. ppm, preferably about 30,000 vol. ppm. It should be noted that wide bandgap energy P-type hydrogenated amorphous silicon, i.e. greater than 1.8 eV, has been fabricated but the material requires $NH_3$ or $CH_4$ or $N_2O$ gas in the growth atmosphere. When the P-type region forms the incident region of the solar cell, a wide bandgap material is preferred.

A transparent electrode layer 16 of, for example, TCO contacts the layer 14c. The TCO layer 16 should be transparent to solar radiation and form an ohmic contact to layer 14c. Optionally, the layer 16 can form an integral anti-reflection coating. The layer 16 can alternatively be of thin transparent metal, such as gold or gold and silver. Preferably the layer 16 has a series resistance less than about 60 ohms per square, more preferably less than about 30 ohms/square and most preferably less than about 20 ohms/square. The layer 16 is typically of the order of a quarter wavelength in thickness or about 70 nanometers.

A grid electrode 18 is deposited on the TCO layer 16. The grid electrode withdraws the current generated during illumination of solar cell 10 by solar radiation 100. The grid electrode 18 can be formed from a highly conductive material, for example, platinum.

An alternative embodiment of the invention is illustrated in FIG. 2. Solar cell 20 has the same substrate 12, and layers 14a and 14b and grid electrode 18 as solar cell 10 in FIG. 1. However, solar cell 20 incorporates a Schottky barrier metal layer 17 which contacts the photoactive compensated intrinsic layer 14b and an optional antireflection coating 19 of material which is transparent to solar radiation, for example $SiO_2$, $ZrO_2$, $Nb_2O_5$, or ZnS. In solar cell 20, the photocurrent generated during illumination is collected and withdrawn by the substrate 12, layer 17 and the grid electrode 18. Optionally, and not illustrated, an insulating layer of, for example, $Nb_2O_5$, $SiO_2$, or $Ta_2O_5$,

of the order of about 2 to 5 nanometers, could be inserted between layer 14b and layer 17 to form what is known in the art as an MIS device. A preferred solar cell would also include a thin reflective metal layer of, for example, aluminium or chromium, on the substrate 12.

The use of minor amounts P-type dopants alone to make the slightly N-type intrinsic amorphous silicon truly intrinsic, does not sufficiently lower the bandgap of the photoactive region towards the ideal bandgap energy of 1.5 eV. Additional P-type dopants lower the bandgap energy and increase the absorption of the photoactive region, but the photoluminescence decreases. Adding N-type dopants compensates the P-type dopants and increases the photoluminescence. The amount of the dopants must be adjusted so that the increase in absorption is not offset by increase in defect sites due to the incorporation of the P-type dopants into the photoactive region.

The cells can be fabricated by methods known in the art such as those disclosed in U.S. Patents 4,064,521, 4,217,148 and 4,226,898.

For example, P-type or $P^+$-type hydrogenated amorphous silicon can be fabricated from $SiH_4 + B_2H_6$, $SiH_4 + H_2 + B_2H_6$, $SiF_4 + H_2 + B_2H_6$, $SiCl_2H_2 + H_2 + B_2H_6$, or the halogenated silicon gases plus hydrogen and a P-type dopant. Wide bandgap P-type material can be fabricated from $SiH_4 + CH_4 + B_2H_6$, $SiH_4 + N_2O + B_2H_6$, $SiH_4 + NH_3 + B_2H_6$, or the halogenated silicon gases and $CH_4$ or $NH_3$. The compensated intrinsic amorphous silicon can be fabricated from $SiH_4 + B_2H_6 + PH_3$, $SiF_4 + H_2 + B_2H_6 + PH_3$, $SiH_4 + H_2 + B_2H_6 + PH_3$, or halogenated silicon gases, hydrogen, diborane and phosphine. N-type or $N^+$-type material can be fabricated from the same materials as the P-type material, except that $PH_3$, $AsH_3$ or other suitable N-type dopant is substituted for the P-type dopant. Suitable substrate forming temperatures are from $250°-350°C$ with a power density of $0.2-2w/cm^2$, a flow rate of 5-50 SCCM and a deposition pressure of 0.1-2 Torr.

Suitable glow discharge apparatus is commercially available, for example the PWS 450 Coyote, a product of Pacific Western Systems, Inc., Mountain View, California, or a Model 2306 of Plasma Systems, Inc., a subsidiary of Plasma-Therm, Inc. Woburn, Massachusetts.

More specifically, a conductive substrate is placed in a glow discharge apparatus, and the pressure is reduced to about $10^{-6}$ Torr. Thereafter, the substrate is heated to about $280°C$. Silane or silane plus methane or $SiH_4 + NH_3$ and phosphine are introduced into the chamber at a flow rate of about 20 SCCM to establish a pressure of about 0.5 Torr. Thereafter, the glow discharge electrodes are energized to a power of about 1 $W/cm^2$ and a layer of N-type hydrogenated amorphous silicon is deposited to a thickness of 10 to 40 nanometers. Thereafter, the concentration of the N-type dopant is reduced and a P-type dopant such as $B_2H_6$ is introduced such that the film has a concentration of boron and phosphorus of the order of from 500 to 1500 vol. ppm. The photoactive intrinsic layer takes about 20 minutes to grow to about a 350-nanometer thick layer. The improved compensated layer has a bandgap of less than 1.6 eV. If the material were not compensated, the bandgap energy would be about 1.8 eV.

Thereafter, the N-type dopant is terminated and the P-type dopant concentration is increased to grow a thin highly doped P-type, preferably a $P^+$-type, layer about 30 nanometers thick containing about 30,000 vol. ppm of the P-type dopant.

Alternatively, the hydrogenated amorphous silicon can be halogenated, i.e. a-Si:F:H, by fabricating the solar cell with $SiF_4$ and $H_2$ in a ratio generally of about 8 parts $SiF_4$ to 1 part $H_2$.

After the deposition of the hydrogenated amorphous silicon layer, a TCO layer is deposited on to the hydrogenated amorphous silicon layer and then a grid electrode is deposited on to the TCO layer by methods known in the art, such as evaporation or photolithography. Alternatively, a cermet layer as taught in U.S. Patent 4,162,505 can be incorporated into the cell.

Although the fabrication has been illustrated for a P-I-N hydrogenated amorphous silicon solar cell, the compensated region of intrinsic hydrogenated amorphous silicon can also be incorporated into a Schottky barrier solar cell, a heterojunction solar cell, an MIS solar cell, an NIP solar cell, or similar semiconductor solar cell which incorporates an intrinsic region of hydrogenated amorphous silicon. The hydrogenated amorphous silicon can also incorporate a halogen. The solar cell can be fabricated as a battery as disclosed in U.S. Patent 4,316,049.

CLAIMS:

1. A hydrogenated amorphous silicon solar cell which includes an electrically conductive substrate in contact with a body of hydrogenated amorphous silicon having layers of differing conductivity with at least one photoactive intrinsic hydrogenated amorphous silicon layer, said body of hydrogenated amorphous silicon having opposed first and second major surfaces, wherein said first major surface contacts said electrically conductive substrate, and means for electrically contacting said second major surface, characterized in that the photoactive intrinsic hydrogenated amorphous silicon layer is compensated by the incorporation therein of N-type and P-type dopants in amounts such as to reduce the bandgap energy of the layer to less than 1.6 eV while ensuring that the recombination lifetime of the photoactive intrinsic layer is greater than the transit time out of said layer of the holes and electrons generated in said photoactive intrinsic layer during illumination of the solar cell.

2. A solar cell as claimed in Claim 1 wherein the P-type and N-type dopants are each present in the photoactive intrinsic layer in an amount of from 500 to 1500 vol. ppm.

3. A solar cell as claimed in Claim 1 or 2, wherein the photoactive intrinsic layer has a bandgap energy of about 1.5 eV.

4. A solar cell as claimed in Claim 1, 2 or 3, wherein the photoactive compensated intrinsic layer is fabricated from an atmosphere comprising silane, phosphine and diborane.

5. A solar cell as claimed in Claim 1, 2, 3 or 4, wherein the cell is a P-I-N solar cell.

6. A solar cell as claimed in Claim 1, 2, 3 or 4, wherein the solar cell is an NIP solar cell.

7. A solar cell as claimed in Claim 1, 2, 3 or 4, wherein said cell comprises an $N^+$-type layer contacting the electrically conductive substrate, a photoactive compensated intrinsic layer contacting said $N^+$-type layer and a Schottky barrier metal layer contacting the photoactive compensated intrinsic layer to form a Schottky barrier solar cell.

8. A method of reducing the bandgap energy of a photoactive intrinsic hydrogenated amorphous silicon layer incorporated in a hydrogenated amorphous silicon solar cell, which method comprises:

incorporating a P-type dopant and an N-type dopant during the growth of said layer in amounts sufficient to reduce the bandgap energy of the photoactive intrinsic hydrogenated amorphous silicon layer to less than 1.6 eV, and to ensure that the recombination lifetime of holes and electrons is greater than the transit time of said holes and electrons out of said photoactive layer during illumination of the solar cell.

9. A method according to Claim 8, wherein the N-type and P-type dopants are incorporated in an amount sufficient to fabricate an intrinsic layer containing N-type and P-type dopant concentrations of the order of 500 to 1500 vol. ppm.

10. A method according to Claim 8 or 9, wherein fabrication of the cell is effected in a glow discharge apparatus.

11. A method according to Claim 10, wherein the fabrication temperature is from 250 to 350°C during deposition.

12. A method according to Claim 10 or 11, wherein the growth atmosphere for the hydrogenated amorphous silicon comprises a silicon-hydrogen-halogen gas.

13. A method according to Claim 10 or 11, wherein the growth atmosphere for the hydrogenated amorphous silicon comprises $SiF_4$ and $H_2$ plus dopant gases.

100

10

14c
14b
14a

18
16

14

12

*FIG.\_1.*

100

20

19
18
17
14b

14a
12

*FIG.\_2.*

European Patent
Office

**EUROPEAN SEARCH REPORT**

Application number

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 3) |
|---|---|---|---|
| D,A | US-A-4 217 148 (D.E. CARLSON) * Column 1, line 38 - column 5, line 21; figures 1, 2 * | 1,4-7, 9-12 | H 01 L 31/06 H 01 L 31/18 |
| A | US-A-4 239 554 (S. YAMAZAKI) * Column 2, lines 9-40; column 3, lines 13-46; column 4, lines 27-62; column 6, lines 25-55; figures 4, 5 * | 1,3-6, 8,12, 13 | |
| A | US-A-4 272 641 (J.J. HANAK) * Column 1, line 17 - column 3, line 48; figures 1, 2 * | 1 | |
| A | EXTENDED ABSTRACTS, vol. 80, no. 1, May 1980, Princeton M.C. CRETELLA et al. "Hydrogenated a-SixGel-x for solar cells", page 896 * Whole document * | 1,8 | TECHNICAL FIELDS SEARCHED (Int. Cl. 3) |
| A | WO-A-7 900 776 (ENERGY CONVERSION DEVICES) * Page 32, line 17 - page 35, line 2 * & US-A-4 226 898 (Cat. D, A) | 4,10, 12,13 | H 01 L 31/00 |

The present search report has been drawn up for all claims

| Place of search BERLIN | Date of completion of the search 30-06-1983 | Examiner ROUSSEL A T |
|---|---|---|

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503. 03.82